(19) Europäisches Patentamt

European Patent Office

Office européen des brevets

(11) **EP 0 697 581 A1**

(12) **EUROPEAN PATENT APPLICATION**

(43) Date of publication:
21.02.1996 Bulletin 1996/08

(51) Int. Cl.$^6$: **G01F 1/10**, G01F 1/05, G01R 27/26

(21) Application number: 94306148.1

(22) Date of filing: 19.08.1994

(84) Designated Contracting States:
DE FR GB

(71) Applicant: Onicon Inc.
Clearwater, Florida 34625 (US)

(72) Inventors:
• Feller, Murray F.
Micanopy, Florida 32667 (US)
• Wiley, Paris H.
Tampa, Florida 33624 (US)

(74) Representative: Marlow, Nicholas Simon
London WC1X 8PL (GB)

(54) **Flow sensor apparatus**

(57) Flow-sensing apparatus is disclosed involving a sensing capacitive electrode whose capacitance is varied by a flow-actuated vaned rotor or an orbiting ball. Sensitivity of the sensor is maintained by connecting the sensing capacitive electrode in series with an impedance that has one terminal of the impedance in close proximity to the sensing capacitive electrode.

FIG. 1

EP 0 697 581 A1

## Description

This invention relates to apparatus for sensing the flow of fluids, both gaseous and liquid, and for measuring the volume and/or flow rate of the sensed fluid.

A well-known form of flow sensors utilizes a flow-driven rotor having vanes that sweep past a sensing electrode or multiple sensing electrodes. Another form of such flow sensors involves a flow-actuated ball that orbits past a sensing electrode. In such apparatus, the electrode or electrodes are ordinarily exposed to the liquid whose flow is to be monitored. Many of such flow sensors, when used for monitoring the flow of water, rely for operation on some significant value of electrical conductivity of the water. They cannot be used for monitoring the flow of high-purity virtually non-conductive water, or with air or other gases, and they do not respond to the flow of non-viscous hydrocarbons which characteristically have extremely high electrical resistivity.

The present invention relates to sensing apparatus involving flow-actuated elements that pass a sensing electrode or electrodes, in which the development of flow-representing signals depends on changes of capacitive impedance between a sensing capacitive electrode and a companion capacitive electrode. Such capacitive flow sensors may comprise only one discrete sensing electrode plus a companion electrode; a variable flow-responsive sensing capacititor is formed between those electrodes. The companion capacitive electrode of the flow-varied sensing capacitor may consist largely of a grounded metal pipe containing the flow sensor, or it may be a metallic structure such as the support for a vaned flow-actuated rotor. The companion electrode may also be a second discrete sensing electrode past which the flow-actuated element travels.

Flow sensors are known that rely at least partially on capacitive changes occurring at a sensing electrode past which a flow-actuated element or elements sweep. The area of a capacitive flow-sensing electrode is typically very small, in contrast to the area of each electrode of an ordinary capacitor. Moreover, the separation between the sensing electrode and its companion electrode typically is enormous, in contrast to the very close spacing of the electrodes of an ordinary capacitor. Both because the area of a sensing electrode is very small and its separation from the companion electrode is great, the capacitance of a capacitive flow-sensor is ordinarily extremely small. Moreover, it should be recognized that, in a flow sensor that relies on capacitive effects to provide flow-representing signals, it is the much smaller flow-induced changes or variation of the intrinsically small capacitance of the flow sensor that is significant -- rather than the total value of the capaciaance.

The sensitivity of a flow-sensing capacitor depends on the flow-induced capacitance changes as a percentage of the total capacitance. Hence, if the sensing structure entails a disproportionately large amount of capacitance that does not vary -- because a large proportion of the metal structure unified with the sensing electrode is not affected by the flow-actuated element(s) -- the resulting sensitivity may be low.

In the illustrative capacitive flow sensors described in detail below, the capacitance between a sensing electrode and its companion electrode is of the order of 1.0pf; in turn, the flow-varied capacitance is a very small percentage of capacitance between the capacitive sensing electrode and its companion electrode. In recognition of the foregoing, the sensing electrode in the present invention is isolated to a large degree from spray capacitances of the connected circuit, and where greatest sensitivity is desired, the circuit itself is of a form that avoids unnecessarily adding non-flow-varied capacitance to the sensing electrode.

The two preferred illustrative embodiments of the invention described in detail below utilize an inductor in series with the sensing capacitor. The series circuit has a junction where the inductor and the sensing electrode are connected to each other, and the series circuit has opposite-end connections at which the external circuit is connected, for applying excitation and for deriving flow-representing signals. Two distinctive factors in those embodiments contribute to avoiding stray or other capacitance being connected to the sensing electrode as a shunt, thereby protecting the sensitivity of the flow sensor. The inductor is located in close proximity to the sensing electrode. Consequently, there is only a minimal length of conductor from the sensing electrode to a terminal of the inductor; their junction thus has correspondingly restricted stray capacitance shunting the sensing capacitor. In those preferred embodiments of the invention, the junction of the sensing electrode and one terminal of the inductor is free of any branch circuit and, accordingly, the sensing electrode is directly connected only to a terminal of the inductor. Both of those factors preclude loading the sensing electrode with avoidable stray capacitance.

The series "L-C" circuit of the inductor ("L") and the sensing capacitance ("Cs") in the two principal embodiments is operated at or close to resonance; it is referred to below at times as a "series-resonant" circuit. The inductor serves as an impedance transformation device, causing a high impedance level to develop at the junction of the sensing electrode and a terminal of the inductor. A low impedance level develops at the opposite-end terminals of the series circuit. The stray capacitance inherent in the circuit connected to the opposite-end terminals of the series conductor-and-sensing capacitance L-C circuit is largely isolated from the sensing electrode by the impedance transformation effect.

The impedance transformation device need not be an inductor. Instead, in a third embodiment of the invention, it is an FET transistor; however, in that case, the necessary circuit connections to the FET device (or its equivalent) add sensitivity-impairing stray capacitance to the junction of the sensing electrode and the FET device.

In the first illustrative embodiment of the novel sensing apparatus described in detail below, which involves series resonance, a constant excitation frequency is involved; the excitation is at a fixed frequency, and an amplitude-modulated flow-monitoring signal is produced. In the second of the embodiments involving series-resonance, the series L-C circuit is a frequency-controlling portion of a frequency-modulated oscillator that yields frequency-modulated flow-monitoring signals. For reasons in the detailed description of these embodiments of the invention, the frequency-modulated apparatus has a distinctive advantage.

A remarkably high level of sensitivity can be attained using the novel sensing apparatus. Because of the high sensitivity; it becomes practical to cover the sensing electrode with a plastic cup which both protecs the electrode against exposure to corrosive fluids to be monitored, and which forms a direct-current barrier in the flow-responsive circuit. Sufficient sensitivity can be attained despite the thickness of the cover of insulation. Additionally, the high sensitivity that is attainable makes it practical to allow substantial clearance between the sensing electrode and the vanes of a flow-actuated rotor; a relatively large clearance between the sensing electrode and the vanes of a flow-actuated rotor protects the rotor against being blocked by fine particles that may be encountered in the fluid to be monitored.

In one of the embodiments of the invention, the frequency of an oscillator is modulated as a flow-actuated element passes a capacitive sensing electrode; and the f-m signal is demodulated in such a manner that pulses are produced as each flow-actuated element passes the sensing electrode. The flow monitoring signal is derived in a simplified detector, as detailed below, by proportioning the oscillator to drop out of oscillation and go back into oscillation as the (each) flow-actuated element traverses the capacitive sensing element.

The nature of the invention, including its advantages and further aspects of novelty, will be better appreciated from the following detailed description of a few illustrative embodiments of various aspects of the invention, considered with the accompanying drawings.

BRIEF DESCRIPTION OF THE DRAWINGS

FIGURE 1 is the longitudinal cross-section of an in-line flow sensor incorporating features of the invention;
FIGURE 2 is an enlarged detail of Fig. 1;
FIGURE 2A is a modification of Fig. 2;
FIGURE 3 is an equivalent circuit diagram of a crystal used as an alternative to a coil;
FIGURE 4 is a frequency-versus-amplitude diagram of a crystal showing its performance as an inductive impedance;
FIGURE 5 is a flow-responsive probe shown in longitudinal cross-section;
FIGURE 5A is a diagrammatic view of the probe of Fig. 5 installed in a pipe;
FIGURES 6 and 7 are alternative diagrams of operating circuits for the apparatus in Figs. 1 and 5;

FIGURE 8 is an equivalent circuit diagram of a portion of Figs. 6 and 7;
FIGURE 9 is a schematic of a capacitive flow-sensor and a semiconductor-follower device as an alternative to the embodiments shown in Figs. 6 and 7;
FIGURE 10 is a diagrammatic representation of a flow-monitoring apparatus involving a frequency-modulated flow-representing signal;
FIGURE 11 is a circuit diagram of an illustrative form of oscillator for the apparatus of Fig. 5;
FIGURE 12 is an equivalent circuit of a series/parallel resonant circuit shown in Fig. 5;
FIGURE 13 is a diagram of impedance-versus-frequency variation of the series/parallel resonant circuit;
FIGURES 14 and 15 are circuit diagrams of oscillators alternative to that of Fig. 11;
FIGURE 16 is a generalized block diagram of an oscillator;
FIGURES 17 and 18 are circuit diagrams of feedback networks for oscillators;
FIGURE 19 is a lateral view, partly in cross-section, of a capacitive flow sensor useful as part of novel flow-sensing apparatus, being a modification of Fig. 5;
FIGURE 20 is a fragmentary cross-sectional view of a further flow sensor useful in the novel flow sensing apparatus; and
FIGURE 21 is a block diagram of a circuit for deriving and utilizing flow-representing signals in flow-sensing apparatus proportioned to operate in an on/off mode.

DETAILED DESCRIPTION OF THE ILLUSTRATIVE EMBODIMENTS

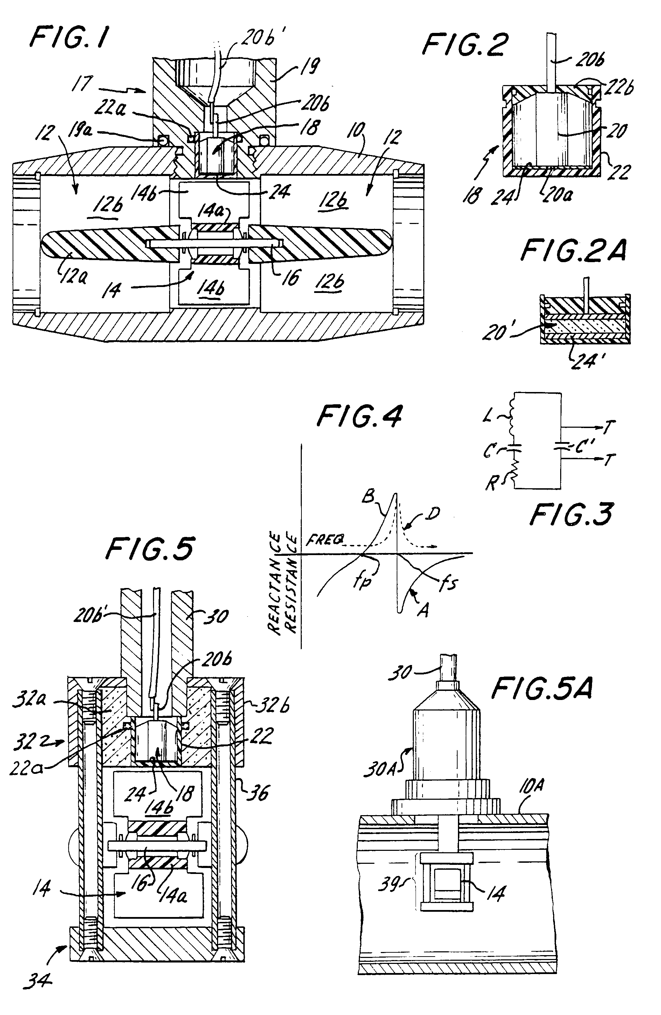

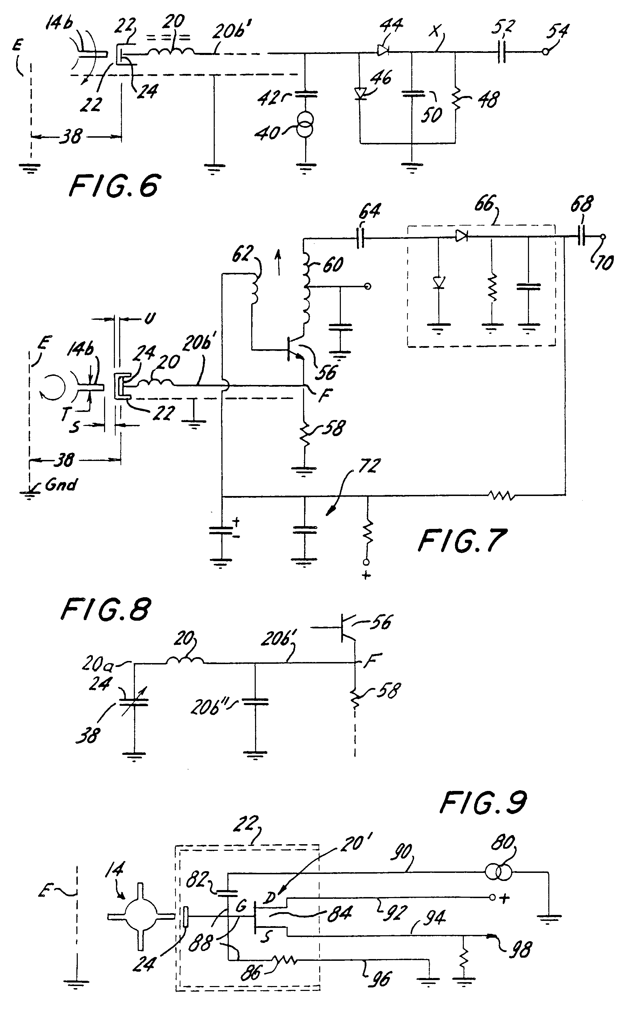

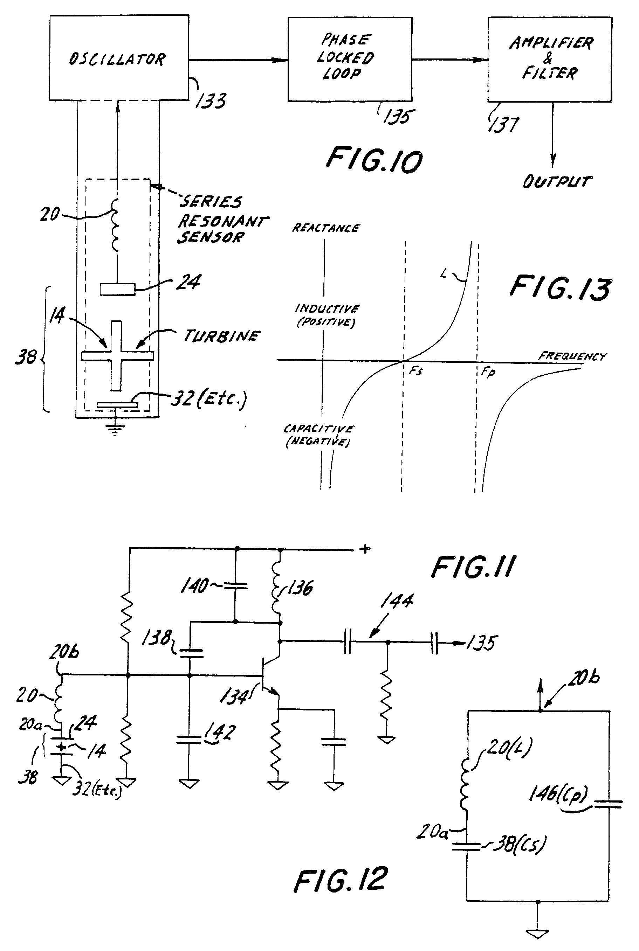

Figs. 6-9 are circuits that involve constant frequency excitation and yield amplitude-modulated signals that signify fluid flow. Figs. 10, 11, 14-18 and 21 are circuits that yield frequency-modulated signals that signify fluid flow. Figs. 1, 2, 2A, 5 and 5A illustrate flow-actuated apparatus useable both in the circuits of Figs. 6-9 and in the circuits of Figs. 10, 11, 14-18 and 21. Reference numerals in Figs. 1, 2, 2A, 5 and 5A are also used in the other figures to represent the same elements.

An in-line flow-sensing structure is shown in Fig. 1, embodying aspects of the invention. In Fig. 1, a short length of metal pipe 10 provides a cylindrical flow passage. Two flow-straightening units 12 are spaced apart in pipe 10, each unit having multiple flow-straightening vanes 12b in planes extending radially outward from hub 12a. A flow-actuated vaned rotor 14 is rotatably supported on shaft 16 that is carried by hubs 12a. Rotor 14 includes a hub 14a and vanes 14b that extend outward of the hub and have spiralled curvature along the hub, resembling turbine blades, so that rotor 14 is actuated by flow of fluid along the pipe. Rotor 14 turns at a rate directly proportional to the flow rate over a wide range of flow rates.

A sensing module 17 is mounted on pipe 10, including a stub 19 that has a threaded end portion screwed into the pipe Appropriate sealing means to prevent leakage should be provided, such as O-ring 19a. Sensing unit 18 is contained in cylindrical cup 22 of molded plastic that fits snugly in a cavity in stub 19. A sealing O-ring 22a on cup 22 prevents leakage past the cup. In unit 18, an inductive impedance 20, which may be a coil on a rigid magnetic core, has one terminal 20a (Fig. 2) joined to sensing electrode 24. This sensing electrode is a metal disc or, alternatively, a coating on the inside bottom surface of the cup or on inductive impedance 20. The cup is spaced reasonably from vanes 14b in the flow passage. Cup 22 is a molded plastic cover over the sensing electrode, protecting it from corrosion or other possible attack by the fluid. As an electrical insulator, the cup also minimizes the effect of the electrical conductivity of the liquid being monitored as a factor in the sensing process. Being largely immune to a wide range of liquid resistivities adapts the apparatus to use with many liquids, without concern for their resistivities, whether high or low. An O-ring seal 22a between cup 22 and head 32 blocks leakage of liquid from the pipe into the probe.

An ideal form of impedance 20 is a coil on a magnetic ceramic core, having terminals 20a and 20b. Coil 20 is spaced from the side walls of cup 22 by cover 22b of the cup, as one way to limit the amount of stray capacitance between the coil (mainly that part of the coil nearest electrode 24) and metal components outside cup 22. Terminal 20a forms -- or is -- a junction or common connection between the coil and electrode 24. In other forms of unit 18, terminal 20a may have some short length, forming a small separation between the coil and the electrode. Inductive impedance 20 may alternatively be a resonant quartz crystal or a resonant ceramic crystal 20' (Fig. 2A). Such crystals have flat metal-film terminals, and then one terminal of a crystal may be arranged to serve as sensing electrode 24'.

Sensing electrode 24 (Figs. 2 and 5) is one terminal of a variable sensing capacitive impedance involving the sensing electrode 24 and a companion electrode which may be a nearby grounded metal structure, and the dielectric in the space between them, mainly the flowing fluid. As will be seen from the following discussion, there may be no grounded metal hearby, and then the companion electrode can be ground of the circuit equipment connected to sensing unit 18.

In operation, excitation impressed on sensing electrode 24 (e.g. 19MHz) causes a distributed field to develop that spreads from the sensing electrode, where it is most concentrated, to any and all conductive material nearby (and distant material, too) which is connected to "ground" of the circuit connected to unit 18.

The distributed field has greatest concentration nearest the sensing electrode, part of the path of the outermost portions of blades or vanes 14b. When the vanes are far from electrode 24, the concentrated field of electrode 24 extends into the space between the blades that is filled by the flowing fluid.

Capacitive sensing electrode 24 and its companion capacitive electrode (ground) and the space between the electrodes and the moving vanes in that space form a flow-varied capacitor or capacitive impedance.

That capacitance and the resulting capacitive impedance at the excitation frequency vary as the rotor blades pass into and out of proximity to electrode 24, on the assumption that the dielectric constant of the rotor's blades differs from the dielectric constant of the rotor-actuating fluid. (If the dielectric constant of the blades is the same as that of the flowing fluid, the blades can by design have a different loss factor than that of the flowing fluid.)

As described above, unit 18 includes an inductive impedance 20 in the form of a coil or, as alternatives, in the form of a quartz crystal wafer or it may be a ceramic polycrystalline wafer. Fig. 3 is the equivalent circuit of a resonant crystal. It includes inductance L and capacitance C between opposite-end terminals T of the series circuit. The inductance L and capacitance C determine the series-resonant frequency of the crystal; and it includes resistance R, being the effective resistance of the crystal that represents electrical loss. Terminals T are commonly conductive films or plates. Capacitance C' of the terminals is in series with the effective capacitance C, forming a capacitance which, with inductance L, form a parallel-resonant circuit. The frequencies of series resonance and parallel resonance are usually quite close to each other.

In Fig. 4, the solid-line curve A represents the reactance of a resonant crystal as it varies with the frequency of an applied excitation signal. The reactance is zero at the parallel-resonance frequency $\underline{fp}$ and at series-resonance frequency $\underline{fs}$. Above the zero line, the reactance is inductive, and below the line the reactance is capacitive. A resonant crystal represents an inductive impedance in that region B of curve A, when excited at a frequency between $\underline{fp}$ and $\underline{fs}$. The dotted-line curve D represents the variation of the effective resistance of the crystal for a range of frequencies. The effective resistance at its maximum is very small, because of low losses of a resonant crystal, especially quartz.

Fig. 5 shows a probe-type flow detector that incorporates unit 18 and other identical components 22 and 24 of Figs. 1 and 2. This flow detector includes a support structure or frame consisting of hollow shaft or stem 30, top and bottom frame elements 32 and 34, and side posts 36, being made at least largely of corrosion-resistant metal. The illustrative probe shown here includes a vaned rotor 14 having a hub 14a and vanes 14b that extend radially outward and that have a spiral twist along the hub. Shaft 16 supports the rotor, in turn carried by suitable bearings fixed to side posts 36. While only one vaned rotor is used in this illustrative probe, it is contemplated that two vaned rotors will be used in the manner and for the purposes explained in U.S. patent 4,379,696 mentioned above, and incorporated here by reference. Shaft or stem 30 extends through a conventional coupling structure 30A that seals the stem to the pipe. Shaft 16 of rotor 14 extends parallel to the flow path. Because the assembly 39 (Fig. 5A) should be small enough to be inserted via a reasonably small hole in the pipe, rotor 14 and its sensing electrode 24 are quite small in practical probes.

Unit 18 (Fig. 2) is contained in cast insulation 32a in a metal cup 32b. In operation, excitation impressed on terminal 20b causes a distributed field to develop which extends from sensing electrode 24 into the path of vanes 14b and to the various metal surfaces of frame structure 30, 32, 34, 36 as well as to any metal pipe 10A (Fig. 5A) in which the probe is mounted. Such structure ordinarily has a wired connection to ground of the circuit equipment that excites the sensing structure and derives flow-representing signals. The pipe may be a section of plastic pipe, without impairing operation of the apparatus. Basically, sensing electrode 24 and ground are the opposite terminals of a variable capacitive sensing impedance.

In the flow detectors of Figs. 1 and 5, the series inductive and capacitive impedances characteristically develop very high excitation voltage at their common connection or junction. The capacitive sensing impedance may have a capacitance of only 1.0 pico farad that is varied by operation of rotor 14. This capacitance includes not only that portion of the electrode's capacitance that is varied by the flow-actuated rotor, but stray capacitance too, i.e., that portion of the total capacitance that is not affected by the blades of rotor 14. A large amount of stray capacitance would reduce the percentage change of the capacitance affected by the rotor blades. Accordingly, any circuit connection to the sensing electrode other than the common connection between the inductive and capacitive impedances should be avoided for greatest efficiency in extracting flow-representing signals. For the same reason, any lead that is used (as in a modified structure) to connect electrode 24 to inductive impedance 20 should by design have a minimum amount of stray capacitance to ground.

Fig. 8 is a diagrammatic representation of the variable sensing capacitance 38 (identified with sensing electrode 24) and inductive impedance 20, their common connection 20a, and wiring 20b' with its stray capacitance 20b''. Components 20, 38 and wiring 20b' with its distributed capacitance 20b'' represent an impedance transforming filter in which, at and near resonance, terminal 20a is at the high-impedance terminal of inductive impedance 20, and wiring 20b' is connected to its low-impedance terminal. By locating the high-impedance terminal of inductive impedance 20 in close proximity to electrode 24 and by virtue of the impedance transformation effect of the inductive impedance in that configuration, the sensing capacitance is largely isolated from the stray capacitance of the circuit wiring.

A basic form of circuit, useful with the flow-detecting structures of Figs. 1 and 5, is shown in Fig. 6. As seen there, a flow-responsive capacitive impedance 38 between sensing electrode 24 and its companion electrode E (ground), made variable by vanes 14b, and inductive impedance 20, are connected to each other as series impedances between lead 20b' and ground. An excitation source 40 is coupled to lead 20b' via capacitor 42. Lead 20b' is connected to a detector comprising a voltage-doubling diode circuit that includes diodes 44 and 46, and a carrier-bypass filter including resistor 48 and capacitor 50. Flow-representing output is coupled by capacitor 52 to terminal 54.

In Fig. 6, sensing capacitive electrode 24 is connected only to coil 20, so that rotor blades 14b have greatest effect in modifying the capacitive impedance. The series impedances 20 and 38 are at or near series resonance at the frequency of excitation source 40 when the vanes are in one position relative to electrode 24. As the rotor turns, the impedance of the series-circuit 20, 38 follows a steep frequency-versus-impedance curve, yielding a flow-representing modulated carrier at wiring 20b' (Fig. 5). The impedance transformation characteristic of the network causes the stray capacitance of wiring 20b' to add but little to the capacitance of electrode 24.

Fig. 7 represents an eminently practical apparatus for providing a flow-representing output signal using the flow-sensing structures of Figs. 1 and 5. The signal results from vanes 14b of the rotor passing capacitive sensing electrode 24. In its usual form, rotor 14 and its blades are of a low-loss plastic having a dielectric constant that contrasts with that of the fluid to be monitored. For example, the dielectric constant of the rotor's plastic may be 2 or 3. That rotor is suitable for sensing the flow of various liquids, and of air which has a dielectric constant of 1.0. In the special circumstance of monitoring the flow of a liquid having approximately the same dielectric constant as that of the vaned rotor, a lossy material for the rotor may be selected, even an conductive rotor may be used, without changing the basic mode of operation. A rotor of conductive material simulates plastic having a very high dielectric constant.

In Fig. 7, a sensing capacitance 38 is formed between the electrode 24 and companion electrode E (ground), and the material in the space between the electrodes. The impedance of the sensing capacitance 38 and inductive impedance 20 form series-connected capacitive and conductive impedances. Excitation is impressed by wiring 20b', being a low-impedance portion of the circuit compared to the high impedance level at electrode 24. The excitation frequency is chosen so that resonance or near-resonance occurs when a rotor vane is opposite to electrode 24 or when two vanes are equally distant, and so that shift of the rotor causes a steep rise of the end-to-end impedance of the series-connected capacitive and inductive impedances.

In Fig. 7, amplifying device 56 is a bipolar transistor. The transistor is part of an amplifier that has a gain-control circuit between its emitter and ground. The gain control circuit comprises resistor 58 and the series-resonant L-C circuit 20, 38 (Figs. 7 and 8). One terminal of the gain control circuit is the junction F of the series resonant circuit, resistor 58 and the transistor's emitter. The opposite terminal of the series-resonant circuit and the opposite terminal of resistor 58 is ground, "Gnd". Resistor 58 provides a high-resistance d-c path to ground for the emitter. The resistance of resistor 58 is large, to limit the gain of the transistor to a low value. Wiring 20b' connects the series-connected inductive and sensing impedances 20 and 38 as a shunt from the emitter to ground, bypassing resistor 58. As rotor 14 turns, the impedance of the series-connected impedances varies widely, from near-zero at resonance, forming a variable gain control impedance for transistor 56 between terminal F and ground Gnd.

Transistor 56 serves both as an oscillator for providing excitation at constant frequency and as an amplifier for flow-representing signals derived from the series-connected impedances 20 and 38. A frequency-determining "tank" circuit 60 is connected to the collector of transistor 56, here being a coil including its distributed capacitance. A regenerative feedback coil 62 is connected between the transistor's base and a biasing network 72 (considered below).

The oscillator's amplitude varies, depending on the gain of the amplifier which, in turn, depends on whether capacitive sensing impedance 38 shifts series-connected impedances 20 and 38 closer to resonance or farther from resonance, as rotor 14 turns. This impedance variation is enhanced and the variation of the oscillator's signal is increased by minimizing the stray capacitance associated with sensing electrode 24. The sensing electrode 24 in an example may be a 0.20-inch diameter disc for responding to a rotor vane 0.035-inch thick of polysulfone. The stray capacitance of wiring 20b' -- including a connection extending along a 15-inch stem of a probe -- might be of the order of 30pf. However, this stray capacitance is on the low impedance side of what is in effect an impedance transformation network. Only a very small fraction of that 30pf is reverse-coupled and thus added to the sensing electrode's capacitance.

The oscillator signal is coupled by capacitor 64 to voltage-doubling demodulator 66, and the flow-representing signal reaches output terminal 70 via d.c. blocking capacitor 68. The output of the demodulator is also impressed on a long-time-constant filter 72 that provides stabilizing bias on the transistor's base.

The series-connected inductive impedance and a small sensing capacitive electrode, constructed and operated as described above, provide novel and unique flow-sensors, notably of the probe type. The very small sensing electrode that senses a vaned rotor of molded insulation is largely unaffected by the stray capacitance of circuit wiring in a long stem of the probe. But the described apparatus is also advantageous in other flow-sensing apparatus, where there may be no probe, even where the flow-actuated device is not a vaned rotor.

Fig. 9 illustrates diagrammatically an alternative form of flow sensor, broadly similar to that of Figs. 1-8 in some respects. In Fig. 9, sensing electrode 24, its companion electrode E and vaned rotor 14 are all as described above, particularly as in Fig. 5 where there is a long supporting stem 30. Also (similar to Fig. 5) a device 20' is assembled to the sensing electrode as part of the probe for providing a large measure of isolation between the sensing electrode 24 and a potentially large amount of stray capacitance of connecting wiring 20b' (Fig. 5) to the circuit that derives the output signal.

In Fig. 9, excitation is coupled from a source 80 of carrier frequency via capacitor 82 to electrode 24. A transistor 84 has a high-impedance input terminal, e.g. the gate of an FET (field-effect transistor), connected to sensing electrode 24 and to a bias-providing resistor 86. Components 82, 84 and 86 form an assembly 20' in close proximity to sensing electrode 24 in cup 22, in place of inductive impedance 20 in Fig. 2. Connections 88 are of minimal length and thickness so as to avoid adding more than minimal stray capacitance to electrode 24. Wires 90, 92, 94 and 96 extend via stem 30 to the exterior of the probe. Capacitor 82 can and should be very small, e.g. 1.0 pf, and resistor 86 may be physically tiny but large in resistance, so as to add only minimal stray capacitance. The gate of transistor 84 and wires 90, 92, 94 and 96 add a small amount of capacitance to electrode 24.

The sensing capacitive impedance comprising electrodes 24 and E and the dielectric in the space between them is rendered variable as the vanes of rotor 14 sweep past electrode 24, as in Figs. 1-8. Transistor 84, having its high-impedance gate G connected to sensing electrode 24 and its low-impedance source S arranged as a signal output connection, constitutes an impedance transformation device in series with the capacitive sensing impedance. The series-connected impedances are connected via output terminal 98 to a circuit (not shown) that amplifies and utilizes the flow-representing signal that develops in response to actuation of rotor 14.

Transistor 84 represents an impedance transformation device incorporated in the probe in close proximity to the sensing electrode. The sensing electrode 24 and the high input impedance terminal of device 84 are at the high impedance level ; and the wiring extending from the FET to an external signal circuit is at the low-impedance level. There are some stray capacitances in Fig. 9 that are not found in Figs. 1-8 as additions to the capacitance identified with Figs. 1-8. Moreover, a probe as in Fig. 9 would subject the transistor to perhaps disabling temperature if high-temperature flow is to be monitored. While the apparatus of Fig. 9 is inferior to that of Figs. 1-8 in these respects, nevertheless Fig. 9 has its own distinctive merit.

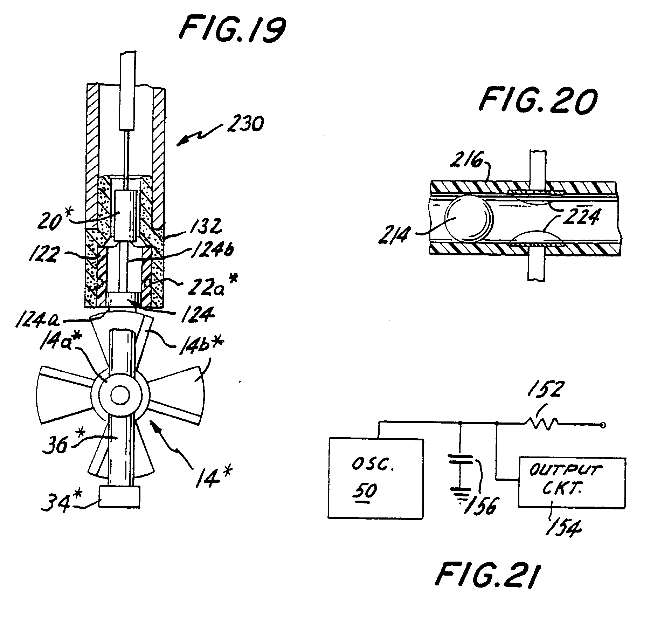

The vaned rotor of Figs. 1-9 is of low-loss insulation, and has a dielectric constant that is distinctly greater than unity, which is the dielectric constant of air. Many liquids also have a dielectric constant that is nearly unity. Where the dielectric constant of a particular liquid to be monitored is close to that of molding materials suitable for the rotor, the rotor can be made lossy as by incorporating carbon particles. But, while the described apparatus involves flow sensing under very difficult conditions, e.g., the detection of changes at the sensing electrode caused by thin vanes of insulation, other forms of flow-actuated device can be substituted as circumstances allow, for example vaned metal rotors, orbital balls (Fig. 20), and so forth.

Figs. 10-21 relate to the form of apparatus involving frequency modulation. In Fig. 10, the sensing capacitive impedance 38 (Figs. 6 and 7) and inductive impedance 20 (e.g., a coil on a magnetic ceramic core) constitute a series circuit having a series-resonant frequency Fs that varies as the rotor's vanes pass the sensing electrode 24. That circuit also has a parallel-resonant frequency Fp (discussed below). Accordingly, the series connected impedances 20 and 38 are at times called a "series/parallel resonant circuit" below.

Series circuit 20, 38 is a frequency-determining portion of oscillator 133 (Fig. 10). A conventional phase-locked loop 135 is a frequency demodulator or detector responsive to frequency variations of the oscillator. Output from frequency demodulator 135 is suitably amplified and filtered in circuit 137 whose output is supplied to any desired utilization devices. An output pulse is developed for every vane 14b of the turbine as it passes electrode 24. The frequency of the pulses represents the rate of flow; each pulse represents an increment of volume that passes the flow sensor, and the integrated succession of pulses represents the volume of flow over any time interval.

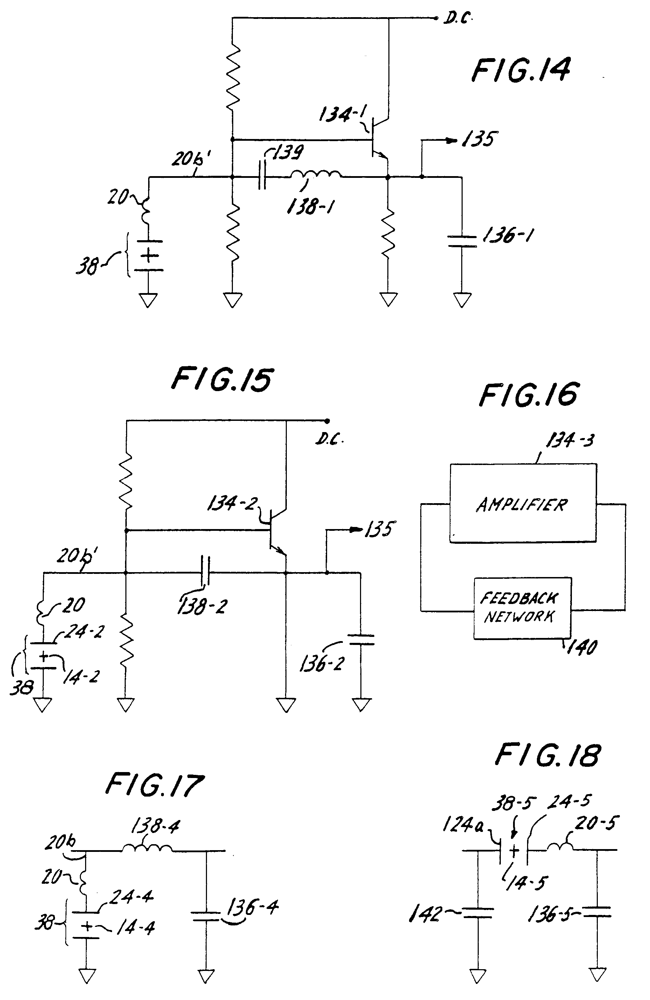

Fig. 11 is the wiring diagram of an oscillator incorporating series/parallel resonant circuit 20, 38 for developing frequency-modulated signals. The oscillator (including flow sensor 38) is proportioned to operate continuously. Each back-and-forth swing of frequencies represents a turbine vane passing the sensing electrode 24. The circuit of Fig. 11 is a basic common-emitter Hartley oscillator having a pi filter or feedback network. Oscillations are sustained for all of the flow-varied values of Cs.

Transistor 134 is an illustrative form of amplifier. The pi feedback network includes coil 136 connected to the transistor's collector as an inductive leg of the pi filter, capacitor 138 is the bridge of the pi, and the series/parallel resonant circuit 20, 38 is the other leg of the pi.

In the distinctive form of the apparatus here being considered, the oscillator is proportioned to operate continuously over the whole range of capacitance variation of the flow sensor 38. Over that range of capacitance variation, circuit 20, 38 is an inductive leg of the pi (note Fig. 13) in the oscillator. The other leg of the pi, consisting primarily of coil 136, is also inductive in the operating range of frequencies. Coil 136, shunted by capacitor 140 if needed, resonates at a frequency that is higher than the upper limit of the operating range of the oscillator. Bridging capacitor 138 of the pi may also be useful as an adjustment to promote sustained operation of the oscillator for the range of variation of the sensing capacitance 38.

Fig. 12 is an equivalent circuit of the series/parallel resonant circuit that primarily comprises the impedances 20 and 38. Sensing capacitive impedance 38 and the series inductive impedance 2 have a series-resonant frequency Fs which varies as the turbne blades traverse electrode 24. Distributed stray or shunt capacitances abound, which in effect extend from end-to-end of the series-connected conductor 20 and the sensing capacitive inductance 38, some small and others more significant; they are lumped in Fig. 12 as a parallel capacitance 146, also designated Cp. The parallel capacitance Cp acting with series/parallel resonant circuit 20, 38 determines a parallel-resonant frequency Fp that is higher than the series-resonant frequency Fs. Increases in the value of Cp -- as by adding capacitor 142 (Fig. 11) -- shift the parallel-resonant frequency Fp closer to the series-resonant frequency Fs. As is explained below, an increase of Cp enhances the proportional effect of flow sensor 38 in causing the oscillator's frequency to vary, thereby increasing the sensitivity of the flow sensing apparatus.

High sensitivity and tolerance of the circuit to appreciable amounts of stray capacitance Cp also contribute to easing constraints in the design of sensing electrode 24 and of the whole flow sensor 20, 38. The capacitive sensing electrode may have substantial thickness, measured perpendicular to disc 24 (Figs. 2 and 5) which may become a plug, thus becoming quite rugged. Terminal 20a of inductor 20 is a direct connection of minimal length that connects the inductor and the sensing capacitive electrode 24 only to each other at the junction of the inductor and the sensing capacitor 38.

High sensitivity of the flow sensor is especially important for allowing relatively wide separation between the face of sensing electrode 24 and the path of the rotor vanes' edges as they pass the sensing electrode. Non-critical spacing or clearance at the vanes' edges promotes good mechanical design of the flow sensor's structure. Wide clearance of the vanes' edges renders the rotor less easily blocked, as by dirt. In addition, ample sensitivity is available even when the bottom of cup 22 is made relatively thick for resisting fluid pressure that may be encountered.

Sensing electrode 24, when formed as a plug, does have stray capacitance to ground. That stray capacitance does not participate in the capacitance variation caused by rotor 14 and thus that stray capacitance degrades and in a sense dilutes the flow-representing capacitance variation. However, accepting some dilution is more than compensated by enabling electrode 24 to be made rugged, in the form of a plug. Ample sensitivity of the flow sensor is readily attainable despite such dilution.

One terminal 20a of inductor 20 is adjacent to --in close proximity to -- sensing electrode 24 so that terminal 20a constitutes a conductor of minimal length that connects inductor 20 directly to the sensing capacitive electrode and only to that electrode. Accordingly, the junction of the inductor and electrode 24 adds no appreciable stray capacitance shunting the sensing capacitance and does not degrade the sensitivity of the flow sensor.

In the following formulas, L is the inductance of coil 20 and Cs is the capacitance of sensor 38. The resonant frequencies Fs and Fp are:

$$Fs = \frac{1}{2\pi\sqrt{L \cdot Cs}} \text{ and } Fp = \frac{1}{2\pi\sqrt{L \cdot Ceq}}$$

$$\text{--where } Ceq = \frac{Cs \cdot Cp}{Cs + Cp}$$

For analysis, it may be considered that Cp is much smaller than Cs. The equivalent capacitance Ceq is then approximately equal to Cp. Then

$$Fp \approx \frac{1}{2\pi\sqrt{L \cdot Cp}}$$

--Fp being virtually independent of Cs. In this condition, changes of Cs occurring as the rotor turns will result in shifts of Fs but Fp remains essentially constant. The operating frequency of the oscillator is between Fs and Fp. In an example, if the highest oscillator frequency is halfway between Fs and Fp, the change in the oscillator frequency due to changes in Cs will be 1/2 the change of Fs.

Continuing the analysis, it may be considered that Cp is much larger than Cs, so that Ceq is approximately equal to Cs and Fs and Fp are very close together. Also, since

$$Fp \approx \frac{1}{2\pi\sqrt{L \cdot Cs}}$$

--Fp will change virtually as much as Fs when the turbine turns and Cs changes. Changes in oscillator frequency during turbine rotation approach the changing Fs. It follows that larger values of Cp promote greater change in oscillator frequency for any given change in Cs. Within eminently practical limits, the circuit tolerates -- and is even helped by -- larger values of Cp. (The result of a large value of Cp is just the opposite in a flow sensor that depends only on the impedance variations caused by flow-activated variations in the sensing impedance, because in such apparatus Cp shunts, and tends to mask the impedance changes.)

The Hartley oscillator form of the flow sensor in Fig. 11 has many attractice attributes. As one advantage, only one discrete connection 20b is made to the sensing probe, greatly simplifying the sensor's construction. This is in contrast to an alternative (see Fig. 18) in which there are two ungrounded connections to the series circuit 20-5, 38-5.

The circuit of Fig. 11 (as already noted) is a Hartley oscillator using a pi feedback network. The common connection of inductive leg 136 and the capacitive bridge 138 of that pi network is to the collector of transistor 134 and the other leg 20, 38 is to the transistor's base. This feedback network is inverting, its connections to the base and to the collector of amplifier 134, respectively, being oppositely phased.

Fig. 14 shows a flow sensor 20, 38 in which a non-inverting pi feedback network is used in a Hartley oscillator. Capacitor 136-1 forms one leg of the pi feedback network, inductor 138-1 forms the bridge and the sensing impedances 20, 38 -- the same as in Fig. 11 -- forms the other leg of the feedback network. The common connection of the inductive bridging impedance 138-1 and the capacitive leg 136-1 is to the emitter of the transistor amplifier 134-1. Output to the phase locked loop 135 (Fig. 10) is taken from the emitter. Capacitor 139 is a large d-c blocking capacitor. The insulating cup 22 (Fig. 5) in the capacitive sensing structure provides d-c blocking in leg 20, 38.

Fig. 15 shows a flow-sensor in which a non-inverting pi feedback network is used in a Colpitts oscillator. Capacitor 136-2 forms one leg of the pi feed-back network, capacitor 138-2 forms the bridge, and the same sensing impedances 20, 38 as in Fig. 11 form the second leg of the pi network. Capacitive impedances 136-2 and 138-2 have a common connection to the emitter of transistor amplifier 134-2. The emitter provides output to phase locked loop 135. In common with the Hartley oscillator of Fig. 11, the Colpitts oscillator of Fig. 15 involves only one connection 20b' to the probe, in addition to the grounded structure.

Considering any oscillator to consist of an amplifier 134-3 and a feedback network 140 (Fig. 16), still other forms of feedback networks can be adopted. The non-inverting pi feedback network in Fig. 17 may replace that in the Hartley oscillator of Fig. 14. In Fig. 17, a capacitor 136-4 forms one leg of the pi network, inductor 138-4 forms the bridge, and the same series sensing impedance 20, 38 as in Fig. 11 forms the second leg of the pi network. The common connection of capacitor 136-4 and inductor 138-4 may be connected to the emitter of a transistor amplifier as in Fig. 14. In this circuit, the series-connected sensing impedances 20, 38 may be interchanged with the bridging impedance 138-4; but then, the rotor sensing structure would need a second discrete sensing electrode that is not grounded.

Fig. 18 illustrates diagrammatically an inverting pi feedback network useful for a Colpitts oscillator, such as that in Fig. 15. This network includes two capacitors 136-5 and 142 as its legs and a modified series/parallel resonant circuit 20-5, 38-5 as its bridge. Sensing capacitance 38-5 includes sensing electrode 24-5 liked electrode 24 (Fig. 5), a second electrode 124a, and turbine rotor 14-5 like that of Fig. 5. Electrode 124a may be an oppositely disposed duplicate of sensing electrode 24-5 with little clearance from the path of the turbine blades' edges. As an alternative, electrode 124a may resemble frame 12 (Fig. 5) provided that such frame is insulated from grounded structures and is arranged (by spacing) as the dominant return electrode for the flux (the field) developed at electrode 24-5.

The oscillator and feedback circuits described above and shown in the drawings are illustrative, but others may be used. Thus, T-type feedback networks can replace pi filters in suitably designed oscillators.

In other forms of flow sensors, turbine rotor 14 is replaced by other forms of flow-activated devices that move repeatedly past the sensing electrode. Other flow-activated rotors include paddle-wheel rotors or simple fans. In still other flow sensors, a flow-activated ball travels in orbits past a sensing electrode or between paired electrodes. See, for example, U.S. patent No. 4,462,262, issued July 31, 1984 to Kahnke. The frequency-modulated oscillator circuits that respond to the turbine blades 14b as discussed above are also highly effective in responding to such alternative flow-activated devices.

The oscillators that utilize flow sensors 38 are in continuous oscillation throughout the range of variation of their sensing capacitances. The impedance of series/parallel circuit 20, 38 remains inductive throughout the frequency range Fs to Fp (Fig. 13), noting that Fs changes as the sensing capacitance Cs changes. The criterion for sustained oscillations is that the loop gain through the amplifier and the feedback network must be greater than unity, at the frequency for which the phase shift of the feedback around the loop is 0°. This criterion is satisfied in ordinary circuit design of the flow-monitoring apparatus thus far described, throughout the range of the capacitive sensor.

Another mode of operation can be achieved with modified apparatus that retains the series/parallel resonant circuit of each apparatus discussed above. In the mode of operation of the modified apparatus, frequency modulated oscillation occurs during part but not all of the range of variation of the sensing capacitance Cs caused by a flow-activated element. During that part of the capacitive sensor's range, the oscillator functions in the same manner as in the apparatus described above: frequency-modulated oscillations are generated. During the remainder of the range of the capacitive sensor's variation, the oscillator drops out of oscillation; the oscillations are interrupted.

This on/off mode of operation depends on the proportions in the design of the oscillator circuit and on related design of the capacitive flow sensor that forms part of the oscillator.

The condition of the modified circuit may be examined at a frequency at which the oscillator drops out of oscillation. This occurs if there is no frequency for which the phase shift of the feedback around the loop of the amplifier and the feedback network is zero. This result occurs, for example, when there is too great a disparity between the effective inductances of leg 136, 140 and leg 20, 38 in Fig. 11, each leg having its own inductive impedance. Low gain of the oscillator's amplifier is another factor promoting the on/off mode of oscillator operation. A still further factor is a capacitive sensing electrode having an especially wide range of capacitance variation in response to the flow-activated element or elements, in turn causing a relatively wide range of series-resonant frequencies.

Figs. 19 and 20 show capacitive flow sensors having relatively wide ranges of sensing capacitance variation. Fig. 19 is a modification of Fig. 5. In Fig. 19, each part bearing a numeral with an asterisk is identical to a like-numbered part in Fig. 5; so that description of such parts is superfluous.

Sensing electrode 124 in Fig. 19 has a head portion 124a and a slender supporting post 124b. (This post may be made shorter than shown.) An insulating sleeve 122 and its support 132 replaces cup 22 and support 32 of Fig. 5, so that the exposed lower surface of sensing head 124a is as close as practical to the sweeping edges of blades 14b*. In this way, the range of variation of the sensing capacitance Cs is increased considerably as compared to the configuration in Fig. 5.

Fig. 20 shows another flow sensor that may be used in place of flow sensor 38. It includes a guide 216 which is part of an orbital track for flow-activated ball 214 made of insulation. The dielectric constant of the ball differs from that of the monitored fluid. Two capacitive electrodes 224 are disposed opposite to each other in the form shown; they have ball-guiding surfaces that are shaped as portions of the ball-guiding track. The liquid whose flow is to be monitored guides the flow so as to cause the ball to orbit past the electrodes repeatedly as in No. 4,462,262 mentioned above. Only one of the discrete electrodes 224 can be used in a modification of Fig 20. In an alternative form of orbital ball flow sensor, the electrodes and the flow-induced ball-orbiting configuration may be that in U.S. patent No. 4,581,943, issued April 15, 1986 to Murray F. Feller: The disclosure of the capacitive ball-sensing electrodes and the ball-orbiting arrangement of the '943 patent are incorporated here by reference.

Relatively large values of ball-sensing capacitance and ranges of capacitance variation are attainable in such orbital ball flow-sensing arrangements and others. They may be part of an oscillator replacing sensing capacitance 38 in Fig. 16 and in Fig. 18, where such oscillators are proportioned as a whole to operate in an alternative on/off mode.

The on/off mode of operation of an oscillator having a capacitive sensor in a series/parallel resonant circuit, proportioned for the on/off mode of operation, can simplify greatly the circuit that derives flow-representing output.

Fig. 21 shows such a circuit. It has a frequency-modulated oscillator 50 having a suitable capacitive flow sensor, and it is proportioned to operate in the on/off mode. A resistor 152 is connected in series with its d-c supply. Changes in current drawn by the oscillator as it goes into and out of oscillation, develop changed voltage drops in resistor 152. Such changes constitute a flow-representing signal. That signal is supplied to output circuit 154. Oscillator-frequency signals are bypassed by capacitor 156.

The flow-sensing apparatus in its various forms detailed above in connection with Figs. 10-21 has many distinctive attributes. As a capacitive-electrode flow sensor, it is usable for monitoring the flow of a wide range of fluids, whether a gas or a resistive liquid or an insulating liquid. It is capable of developing ample flow-representing signals even when the capacitive flow sensor has an extremely small sensing electrode that is used to respond to slim flow-activated blades or vanes.

The coil and the series-connected capacitive sensor in each embodiment of Figs. 10-21 form a series-resonant circuit that is at times referred to herein as a series/parallel resonant circuit; it has a series-resonant frequency Fs and a parallel resonant frequency Fp. The inherent stray capacitance that is a shunt across the series-connected impedances does not degrade the capacitive flow sensor's sensitivity. As demonstrated above, the sensitivity of the sensor is actually enhanced by that stray capacitance.

The various forms of the apparatus detailed above have their own distinctive properties, as noted above.

The illustrative forms of apparatus described above and shown in the drawings may be modified and variously applied by those skilled in the art. Consequently, the invention should be broadly construed in accordaince with its true spirit and scope.

## Claims

1. Apparatus for sensing the flow of fluid, including a sensing capacitor comprising a capacitive sensing electrode and a companion electrode and a flow-actuated element operable to vary the capacitance between said electrodes, and an impedance-providing device having a first terminal connected at a junction to said sensing electrode, said impedance providing means having a second terminal, said sensing capacitor and said impedance-providing device forming a series circuit having separate terminals at which an activating circuit may be connected, characterized in that said first terminal of said impedance-providing device is in close proximity to and is connected directly to said sensing electrode.

2. Apparatus for sensing the flow of fluid as in claim 1, further characterized in that said impedance-providing device is effective as an impedance-transformation device such that said junction operates at a high level of impedance and the level of impedance at said separate terminals of said series circuit is contrastingly low.

3. Apparatus for sensing the flow of fluid as in claim 1 or 2, further characterized in that only said first terminal of said impedance-providing device and said capacitive sensing electrode are connected at said junction.

4. Apparatus for sensing the flow of fluid as in claim 1, 2 or 3, further characterized in that said impedance-providing device is an inductor which, with said sensing capacitor, forms a series-resonant circuit.

5. Apparatus for sensing the flow of fluid as in any of the preceding claims, further characterized in that the apparatus includes means for applying excitation to and for deriving flow-monitoring signals from said separate terminals of the series circuit.

6. Apparatus for sensing the flow of fluid as in any of the preceding claims, further characterized in that said impedance providing means is an inductor and in that said apparatus includes an oscillator for causing excitation to bed impressed between said separate terminals at a constant frequency at least close to the series-resonant frequency of said series circuit.

7. Apparatus for sensing the flow of fluid as in claim 5, further characterized in that said impedance providing means is an inductor and in that said apparatus includes an oscillator that operates at a constant frequency at least close to the series-resonant frequency of said series circuit and wherein said apparatus includes a variable-gain amplifying device as part of said oscillator and as part of the means for deriving flow-monitoring signals, for controlling both the amplitude of oscillations and the amplitude of the flow-monitoring signals.

8. Apparatus for sensing the flow of fluid as in any of claims 1-5, further characterized in that said series circuit is a series/parallel resonant circuit that forms part of a frequency-modulated oscillator, the frequency of the oscillator being between the series-resonant frequency Fs and the parallel-resonant frequency Fp of said series circuit.

9. Apparatus for sensing the flow of fluid as in claim 8, further characterized in that said oscillator is proportioned for maintaining oscillation during operation of said flow-actuated element through only part of the range of that element in relation to said sensing electrode, said oscillator drawing different levels of energizing current when in oscillation and when not in oscillation, said apparatus including a detector responsive to the different levels of energizing current of the oscillator for producing flow-representing signals.

FIG.1

FIG.2

FIG.2A

FIG.4

FIG.3

FIG.5

FIG.5A

FIG.6

FIG.7

FIG.8

FIG.9

FIG.10

FIG.13

FIG.11

FIG.12

FIG.14

FIG.15

FIG.16

FIG.17

FIG.18

FIG.19

FIG.20

FIG.21

European Patent
Office

**EUROPEAN SEARCH REPORT**

Application Number

EP 94 30 6148

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | FR-A-2 209 105 (DJIAN)<br>* the whole document * | 1-7 | G01F1/10<br>G01F1/05<br>G01R27/26 |
| D,A | US-A-4 581 943 (FELLER)<br>* the whole document * | 1-7 | |
| D,A | US-A-4 462 262 (KAHNKE)<br>* the whole document * | 1,2,4-7 | |
| A | US-A-4 324 144 (MIYATA ET AL.)<br>* the whole document * | 1,5,8 | |

TECHNICAL FIELDS
SEARCHED      (Int.Cl.6)

G01F
G01R

The present search report has been drawn up for all claims

| Place of search | Date of completion of the search | Examiner |
|---|---|---|
| THE HAGUE | 25 January  1995 | Rose, A |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document